(19) Europäisches Patentamt
European Patent Office
Office européen des brevets

(11) **EP 4 603 851 A1**

(12) **EUROPEAN PATENT APPLICATION**
published in accordance with Art. 153(4) EPC

(43) Date of publication:
**20.08.2025   Bulletin 2025/34**

(51) International Patent Classification (IPC):
**G01R 31/382** (2019.01)      **G01R 31/385** (2019.01)

(21) Application number: **23933868.4**

(52) Cooperative Patent Classification (CPC):
**Y02E 60/10**

(22) Date of filing: **07.12.2023**

(86) International application number:
**PCT/CN2023/137271**

(87) International publication number:
**WO 2024/217003 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:  **20.04.2023   CN 202310436085**

(71) Applicant: Eve Power Co., Ltd.
**Jingmen, Hubei 448000 (CN)**

(72) Inventors:
• LI, Xia
  **Jingmen, Hubei 448000 (CN)**
• GAO, Zhiyong
  **Jingmen, Hubei 448000 (CN)**
• SU, Bin
  **Jingmen, Hubei 448000 (CN)**
• CHEN, Liquan
  **Jingmen, Hubei 448000 (CN)**

(74) Representative: **Herrero & Asociados, S.L.**
**Cedaceros, 1**
**28014 Madrid (ES)**

(54) **SCREENING METHOD AND APPARATUS REGARDING SELF-DISCHARGE OF LITHIUM-ION BATTERIES, AND ELECTRONIC DEVICE**

(57)    A self-discharge screening method for lithium-ion batteries, a self-discharge screening apparatus for lithium-ion batteries, and an electronic device. A single batch screening objects of the method include batteries to be screened placed in a plurality of trays. Each tray is placed with a plurality of the batteries to be screened. In a screening process, voltage drops per unit time of a plurality of batteries to be screened are measured (S101), and voltage drop screening thresholds of the plurality of trays are determined according to the voltage drops per unit time of the batteries to be screened in the tray (S102).

Measuring voltage drops per unit time of a plurality of batteries to be screened — S101

Determining voltage drop screening thresholds of a plurality of trays according to the voltage drops per unit time of the batteries to be screened in the trays — S102

Screening out unqualified batteries in the plurality of trays respectively according to a relative relationship between the voltage drop screening threshold of the tray and the voltage drops per unit time of a plurality of batteries to be screened in the tray — S103

FIG. 2

EP 4 603 851 A1

## Description

The present disclosure claims priority to Chinese Patent Application No. 202310436085.7, filed with the Chinese Patent Office on April 20, 2023, the disclosure of which is incorporated herein by reference in its entirety.

## TECHNICAL FIELD

The present disclosure relates to battery testing technologies, and for example, to a self-discharge screening method and a self-discharge screening apparatus for lithium-ion batteries, and an electronic device.

## BACKGROUND

In an open-circuit state, a phenomenon that electricity consumption of lithium-ion batteries occurs over time is referred to as self-discharge phenomenon of lithium-ion batteries, which is an inherent property of the lithium-ion batteries. In a lithium-ion battery system, when the self-discharge phenomenon of a battery is severe, the performance of the entire battery system will decline. Therefore, before lithium-ion batteries are released to end consumers for use, it is particularly important for manufacturers to sort out batteries with excessive self-discharge by using self-discharge screening technology.

At present, a self-discharge screening method adopted by most battery manufacturers is a fixed K value (also known as voltage drop per unit time) screening method. This screening method is easy to implement and low-cost, thereby greatly improving the factory yield of batteries.

However, in large-scale production, the fixed K value screening method shows poor measurement accuracy, affecting the factory quality of the batteries.

## TECHNICAL PROBLEM

The present disclosure provides a self-discharge screening method and a self-discharge screening apparatus for lithium-ion batteries, and an electronic device, to improve the accuracy of the self-discharge screening of lithium-ion batteries.

## TECHNICAL SOLUTION

According to a first aspect, the embodiments of the present disclosure provide a self-discharge screening method for lithium-ion batteries. A single-batch selection object of the self-discharge screening method for lithium-ion batteries includes batteries to be screened placed in a plurality of trays. Each tray is placed with a plurality of the batteries to be screened.

The self-discharge screening method for lithium-ion batteries includes:

measuring voltage drops per unit time of a plurality of the batteries to be screened;

determining voltage drop screening thresholds of the plurality of trays according to the voltage drops per unit time of the batteries to be screened in the tray; and

screening out unqualified batteries in the plurality of trays respectively according to a relative relationship between the voltage drop screening threshold of the tray and the voltage drops per unit time of the plurality of batteries to be screened in the tray

According to a second aspect, the embodiments of the present disclosure further provides a self-discharge screening apparatus for lithium-ion batteries. The self-discharge screening apparatus for lithium-ion batteries includes a voltage drop measurement module, a threshold determination module, and a screening module.

The voltage drop measurement module is configured to measure voltage drops per unit time of a plurality of batteries to be screened.

The threshold determination module is configured to determine voltage drop screening thresholds of a plurality of trays according to the voltage drops per unit time of the batteries to be screened in the trays.

The screening module is configured to screen out unqualified batteries in the plurality of trays respectively according to a relative relationship between a voltage drop screening threshold of the tray and the voltage drops per unit time of a plurality of batteries to be screened in the tray.

According to a third aspect, the embodiments of the present disclosure further provides an electronic device. The electronic device includes:

at least one processor; and
a memory communicatively coupled to the at least one processor; wherein,
the memory stores a computer program executable by the at least one processor. The computer program, when executed by the at least one processor, cause the at least one processor to perform the self-discharge screening method for lithium-ion batteries according to any one of the first aspect.

## BENEFICIAL EFFECTS

Beneficial effects of the present disclosure: according to the self-discharge screening method and apparatus for lithium-ion batteries, and the electronic device provided by the present disclosure, a single batch screening objects include batteries to be screened placed in a plurality of trays. Each tray is placed with a plurality of the batteries to be screened. During a screening process, the voltage drops per unit time of a plurality of batteries to be screened are measured, and voltage drop screening thresholds of the plurality of trays are determined according to the voltage drops per unit time of the batteries to be screened in the trays. According to a relative relationship between the voltage drop screening threshold of the tray and the voltage drops per unit time of the plurality of batteries to be screened in the tray, the unqualified batteries in the plurality of trays are screened out respectively, thereby realizing self-discharge screening of the batch of lithium-ion batteries. The screening threshold of the tray is determined according to the voltage drops per unit time of the plurality of batteries to be screened in the tray, thereby avoiding the temperature influence caused by long distance among batteries to be screened during a standing process, which not only reduces the temperature control cost of the manufacturer, but also improve the accuracy of the self-discharge screening of the lithium-ion batteries.

**BRIEF DESCRIPTION OF THE DRAWINGS**

FIG. 1 is a variation curve of a voltage of a lithium-ion battery with respect to a standing temperature according to the present disclosure;
FIG. 2 is a schematic flowchart of a self-discharge screening method for lithium-ion batteries according to embodiments of the present disclosure;
FIG. 3 is a schematic flowchart of another self-discharge screening method for lithium-ion batteries according to embodiments of the present disclosure;
FIG. 4 is a schematic flowchart of yet another self-discharge screening method for lithium-ion batteries according to embodiments of the present disclosure;
FIG. 5 is a schematic diagram of an SOC-V relationship curve and an SOC-dV/dQ relationship curve of a lithium iron phosphate battery according to embodiments of the present disclosure;
FIG. 6 is a schematic flowchart of still another self-discharge screening method for lithium-ion batteries according to embodiments of the present disclosure;
FIG. 7 is a schematic diagram of a variation curve of a voltage of a lithium-ion battery with respect to a standing time according to the present disclosure;
FIG. 8 is a distribution diagram of K values of batteries to be screened in some trays of a single batch screening objects according to embodiments of the present disclosure;
FIG. 9 is a schematic diagram of a composition of a self-discharge screening apparatus for lithium-ion batteries according to embodiments of the present disclosure.

**DETAILED DESCRIPTION**

It is configured as described in the background, a self-discharge screening method adopted by most battery manufacturers is a fixed K-value screening method, where the K value is a voltage drop per unit time of a lithium-ion battery. A specific expression of a fixed K value screening method is $K = \Delta V/\Delta t$, in which K is a K value, i.e. a voltage drop per unit time of a lithium-ion battery; $\Delta V$ is a voltage drop generated during a period from when an open-circuit voltage of the battery is a first open-circuit voltage OCV1 to when the open-circuit voltage of the battery is a second open-circuit voltage OCV2, and its expression is $\Delta V = OCV1 - OCV2$; $\Delta t$ is a time difference between the measurement of the first open-circuit voltage OCV1 and the measurement of the second open-circuit voltage OCV2, and its expression is $\Delta t = t_{OCV2} - t_{OCV1}$, in which $t_{OCV2}$ is the time for measuring the second open-circuit voltage OCV2, and $t_{OCV1}$ is the time for measuring the first open-circuit voltage OCV1. A screening standard for the K value is a fixed value. If the K value of the battery is greater than this fixed value, the battery is determined to be an unqualified battery with a self-discharge rate exceeding the standard. However, in large-scale production, the fixed K value screening method shows poor measurement accuracy, affecting the factory quality of the batteries.

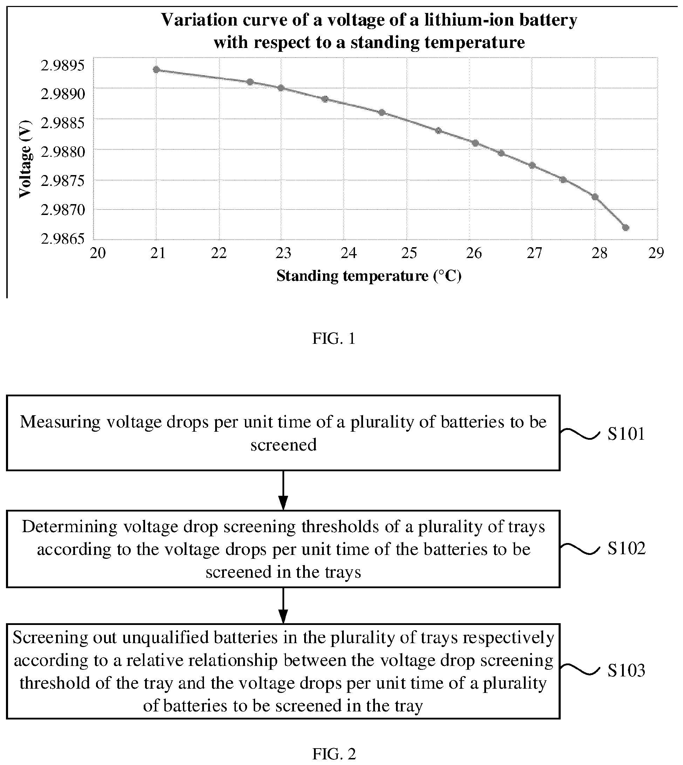

The inventors have found through research that the K value of a lithium-ion battery is affected by many factors, and may be determined by a variant of an Arrhenius equation. The variant of the Arrhenius equation is $Q_{self} = A e^{-(Ea/RT)} * t^z$, in which $Q_{self}$ is a capacity lost by self-discharge; Ea is an apparent activation energy, which indicates a difficulty of the self-discharge reaction, and is related to a charged state of a battery; T is a standing temperature; t is a standing time; A is a pre-exponential coefficient; R is an ideal gas constant, the value of which is 8.314J/(mol*K); Z is a power coefficient, which is generally a constant. According to the variant of the Arrhenius equation, it can be determined that the standing temperature is one of important factors affecting the K value of lithium-ion batteries. FIG. 1 is a variation curve of a voltage of a lithium-ion battery with respect to a standing temperature according to the present disclosure. Combined with FIG. 1, the inventors further studied and have found that the battery voltage is significantly affected by the standing temperature, and even for the same battery, the K values determined under different standing temperature conditions will be different. Therefore, in order to accurately screen for self-discharge, it is necessary to strictly control the temperature during the battery self-discharge test. However, in the manufacturing process of a large batch of batteries, the height of a standing warehouse is often up to ten meters, so that a plurality of batteries in the standing warehouse are often far away from each other (either horizontally or vertically). In addition, the heat generation of a plurality of batteries during the self-discharge process is also different. In this case, the cost of extreme temperature control is too high. Extreme temperature control of multiple locations in the standing warehouse is impractical for large scale manufacturing of enterprises. However, using the screening method mentioned in the background to perform self-discharge screening on lithium-ion batteries cannot consider a temperature difference among a plurality of batteries at multiple positions, which results in a poor screening effect. Therefore, how to take into account the cost and the accuracy of screening has become one of the technical challenges that lithium-ion battery manufacturers have been working hard to overcome.

Based on this, in the present patent, when self-discharge screening is performed on batch batteries, the trays are taken as the smallest screening units, to ensure that the standing temperatures of the batteries in each of the trays are the same, so as to eliminate interference from external environment to the maximum extent. On this basis, other technical means are combined to improve the effectiveness of self-discharge screening of batch batteries. The above is the main inventive concept of the present disclosure.

In order to solve the foregoing problems, the embodiments of the present disclosure provide a self-discharge screening method for lithium-ion batteries. In the self-discharge screening method for lithium-ion batteries, a single batch screening objects include batteries to be screened placed in a plurality of trays. Each tray is placed with a plurality of the batteries to be screened. FIG. 2 is a schematic flowchart of a self-discharge screening method for lithium-ion batteries provided by the embodiments of the present disclosure. Referring to FIG. 2, the self-discharge screening method for lithium-ion batteries includes:

Step S101, measuring voltage drops per unit time of a plurality of batteries to be screened.

Specifically, a single batch screening objects include a plurality of batteries to be screened that are placed in a plurality of trays. When measuring a voltage drop (hereinafter referred to as K value for short) per unit time of the battery to be screened, differences between the open-circuit voltages of the battery to be screened before and after standing can be measured, and then the voltage drop per unit time of the battery to be screened can be calculated according to a standing duration and the difference between the open-circuit voltages. This step may be implemented by using any K value test method in relevant technologies, which will not be introduced in detail herein.

S102, determining voltage drop screening thresholds of a plurality of trays according to the voltage drops per unit time of the batteries to be screened in the trays.

Specifically, a single batch screening objects include a plurality of batteries to be screened. For example, the single batch screening objects may include thousands or tens of thousands of batteries to be screened. The plurality of batteries to be screened are separated and packed in a plurality of trays. For example, the number of batteries to be screened in one single tray may be 16 to 40. For example, the number of batteries to be screened in each tray may be equal to 16. The voltage drop screening threshold of the tray refers to a threshold that may be configured to determine whether the K values of the plurality of batteries to be screened in the tray exceed a normal range. The threshold may be an upper boundary of the normal range of the K values of the plurality of batteries to be screened in the tray. If the K value of any battery to be screened in the tray exceeds the voltage drop screening threshold of the tray, it may indicate that the self-discharge rate of the battery to be screened is unqualified. According to the K values of the plurality of batteries to be screened in the tray, an average level of the K values of the plurality of batteries to be screened in the tray may be determined. For example, the average level of the K values of the plurality of batteries to be screened in the tray may be represented by an average value or a tail-removed average value of the K values of the plurality of batteries to be screened in the tray. The voltage drop screening threshold of the tray can be determined according to the average level of the K values of the plurality of batteries to be screened in the tray. For example, the voltage drop screening threshold of the tray can be calculated by adding a preset error value on the basis of the average value of the K values of the plurality of batteries to be screened in the tray, where the preset error value can be determined according to factory requirements of the battery and a material system of the batteries to be screened.

S103, screening out unqualified batteries in the plurality of trays respectively according to a relative relationship between the voltage drop screening threshold of the tray and the voltage drops per unit time of the plurality of batteries to be screened in the tray.

Specifically, according to the voltage drop screening threshold of the tray, it is determined whether the K values of the plurality of batteries to be screened exceed a normal range. if the K value exceed the normal range, the battery to be screened is determined to be an unqualified battery; if the K value do not exceed the normal range, the battery to be screened is determined to be a qualified battery. For example, all batteries to be screened with a K value greater than a voltage drop screening threshold of a tray where the battery to be screened is located may be determined as an unqualified battery.

According to the self-discharge screening method for lithium-ion batteries provided in the embodiments of the present disclosure, a single batch screening objects include batteries to be screened placed in a plurality of trays. Each tray is placed with a plurality of the batteries to be screened. During a screening process, the voltage drops per unit time of a plurality of batteries to be screened are measured, and voltage drop screening thresholds of the plurality of trays are determined according to the voltage drops per unit time of the batteries to be screened in the trays. According to a relative relationship between the voltage drop screening threshold of the tray and the voltage drops per unit time of a plurality of batteries to be screened in the tray, the unqualified batteries in the plurality of trays are screened out respectively, thereby realizing self-discharge screening of the batch of lithium-ion batteries. The screening threshold of the tray is determined according to the voltage drops per unit time of the plurality of batteries to be screened in the tray, thereby avoiding the temperature influence caused by long distance among batteries to be screened during a standing process, which not only reduces the temperature control cost of the manufacturer, but also improve the accuracy of the self-discharge screening of the lithium-ion batteries.

Combined with the variant of the Arrhenius equation, it can also be determined that the state of charge of the battery is also one of the important factors affecting the K value of the lithium-ion battery. Therefore, based on the foregoing embodiments, before measuring the voltage drops per unit time of the plurality of batteries to be screened, it is necessary to adjust the state of charge of the lithium-ion batteries, to adjust the state of charge of the batteries to be screened in the tray to the same value. The determination of an adjustment value of the state of charge needs to be further investigated.

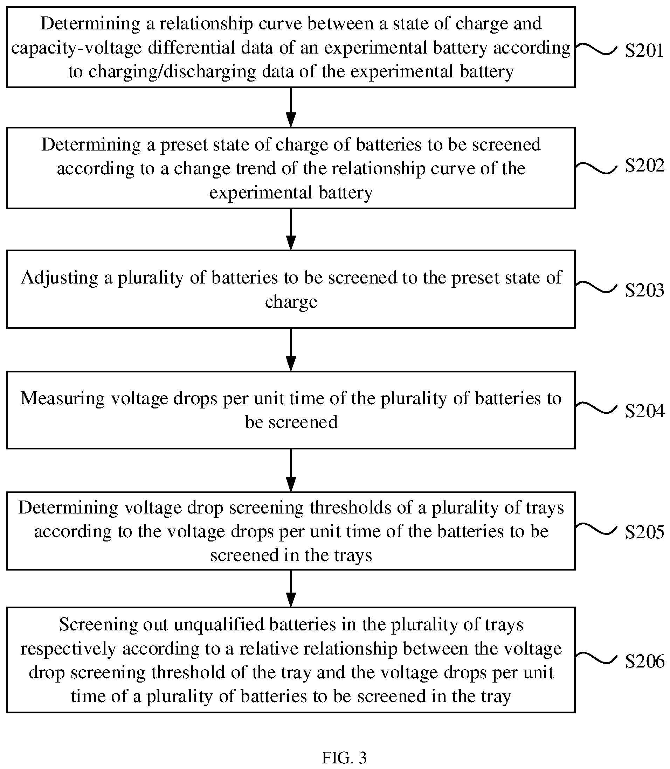

FIG. 3 is a schematic flowchart of another self-discharge screening method for lithium-ion batteries provided by the embodiments of the present disclosure. Referring to FIG. 3, the self-discharge screening method for lithium-ion batteries includes:
S201, determining a relationship curve between a state of charge and capacity-voltage differential data of an experimental battery according to charging/discharging data of the experimental battery.

A material system of the experimental battery is the same as that of the batteries to be screened. The experimental battery refers to a battery that has the same material system as that of the battery to be screened and is configured to perform charge-discharge experiments. The same material system means that the active materials and charging and discharging principles used in the lithium-ion batteries are the same. The material system may also be referred to as a negative electrode system. For example, the material system of a lithium cobalt oxide battery is lithium cobalt oxide, and the material system of a lithium iron phosphate battery is lithium iron phosphate. The capacity-voltage differential data refers to data including a differential quantity of a capacity and a differential quantity of a voltage, and the differential quantity may be a first-order differential or a multi-order differential. For example, the capacity-voltage differential data may be a ratio $dV/dQ$ of a differential voltage to a differential capacity.

Specifically, a small current below 0.05C is used to perform a charge-discharge experiment on an experimental battery, and charging/discharging parameters are recorded. For example, the charging/discharging parameters may include electric quantity and voltage data. After obtaining the charging/discharging data, it is necessary to process the charging/discharging data to remove obvious erroneous data. The capacity-voltage differential data of the experimental battery is determined according to the charging/discharging data. By using the capacity-voltage differential data as a vertical coordinate and using the state of charge, etc. as a horizontal coordinate, a standard relationship curve between the state of charge and the capacity-voltage differential data can be obtained.

For example, a small current of 0.04C is used to charge and discharge the experimental battery, and the electric quantity and voltage of the experimental battery during the charging and discharging process are recorded. After obtaining these data, first removing obvious erroneous data points in these data, and then subtracting voltage and electric quantity data of a previous data point from the voltage and electric quantity data corresponding to each data point, so as to obtain dV data and dQ data of the data point. By processing all the data in sequence, a series of dV data and dQ data can be obtained, and then dQ is divided by dV to obtain a capacity-voltage differential data of the experimental battery, i.e., the ratio $dV/dQ$ of a differential voltage to a differential capacity. Then, by using $dV/dQ$ as a vertical coordinate and using the state of charge as a horizontal coordinate, a standard relationship curve between the state of charge and $dV/dQ$ can be obtained.

S202, determining a preset state of charge of batteries to be screened according to a change trend of the relationship curve of the experimental battery.

Specifically, the preset state of charge may be a determined value, and may also be an interval. The relationship curve between the state of charge and the capacity-voltage differential data of the experimental battery, may reflect the capacity of the lithium-ion battery of the material system in a unit voltage range under different states of charge. A change trend of the relationship curve can be reflected in a fluctuation of the capacity-voltage differential data with the change of the state of charge during the charging and discharging process. If a fluctuation rate of the capacity-voltage differential data in a certain state of charge interval, is larger that in other state of charge intervals, it may indicate that the voltage change caused by self-discharge in this state of charge interval is more significant. For example, a slope of the relationship curve may represent a rate of change in the fluctuation of the capacity-voltage differential data with respect to the state of charge. Therefore, a low-charge interval and a high-charge interval in a state of charge interval where an absolute value of the slope of the relationship curve is greater than a preset value can be removed to determine the preset state of charge of the battery to be screened. Under the preset state of charge, the voltage drop of the battery per unit time varies greatly with the unit state of charge, which can reduce the impact of system errors on a screening result.

S203, adjusting a plurality of batteries to be screened to the preset state of charge.

Specifically, a charging and discharging apparatus is used to perform charging or discharging operations on all batteries to be screened, so that the states of charge of the batteries to be screened are unified to a preset state of charge, so as to facilitate subsequent further screening.

S204, measuring voltage drops per unit time of the plurality of batteries to be screened.

S205, determining voltage drop screening thresholds of a plurality of trays according to the voltage drops per unit time of the batteries to be screened in the trays.

S206, screening out unqualified batteries in the plurality of trays respectively according to a relative relationship between the voltage drop screening threshold of the tray and the voltage drops per unit time of a plurality of batteries to be screened in the tray.

Step S204, step S205, and step S206 are the same in detail as step S101, step S102, and step S103 in one-to-one correspondence, and details are not repeated herein.

According to the self-discharge screening method for lithium-ion batteries provided by this embodiment, before measuring the voltage drops per unit time of a plurality of batteries to be screened, an experimental battery with the same material system as that of a current batch screening objects is used to determine the preset state of charge. In this process, a relationship curve between a state of charge and capacity-voltage differential data of the experimental battery is determined according to charging/discharging data of the experimental battery, and then the preset state of charge of the battery to be screened is determined according to a change trend of the relationship curve of the experimental battery. The states of charge of the plurality of batteries to be screened are adjusted to the preset state of charge, and then further screening is performed. Due to the different voltage drops caused by self-discharge of a fixed amount of electricity from the batteries to be screened under different states of charge, the uniform adjustment of the state of charge to the preset state of charge can avoid the influence of the states of charges on the K values of a plurality of batteries to be screened, and the accuracy of self discharge screening can be further improved.

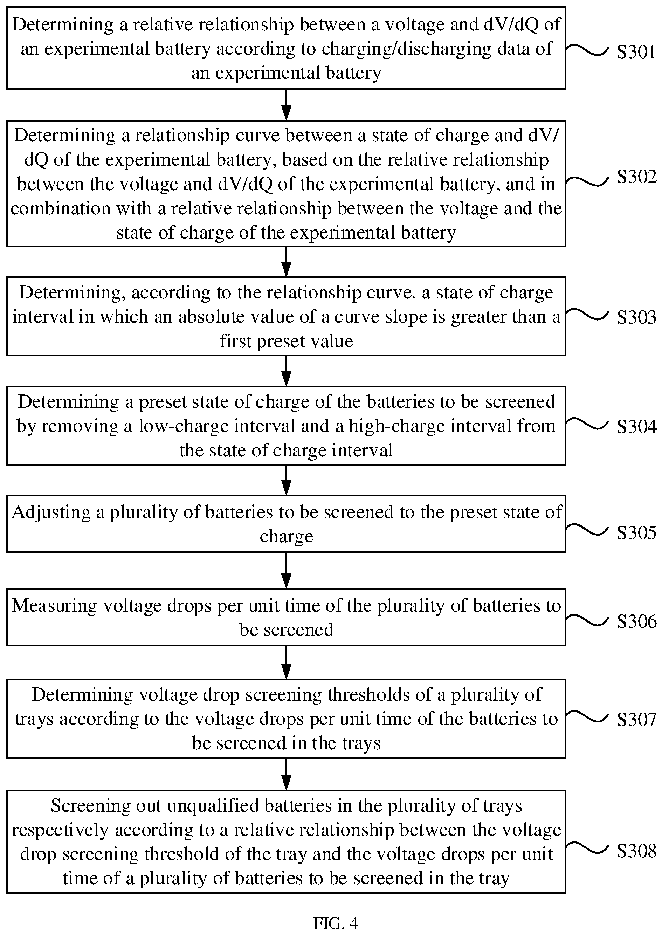

FIG. 4 is a schematic flowchart of yet another self-discharge screening method for lithium-ion batteries according to the embodiments of the present disclosure. Referring to FIG. 4, material systems of the experimental battery and the batteries to be screened may both be lithium iron phosphate, the capacity-voltage differential data includes a ratio dV/dQ of a differential voltage to a differential capacity. On this basis, the self-discharge screening method for lithium-ion batteries may include: S301, determining a relative relationship between a voltage and dV/dQ of an experimental battery according to charging/discharging data of an experimental battery.

Specifically, a small current is used to perform a charge-discharge experiment on an experimental battery, where the small current may be 0.04 C. By measuring electric quantity data and voltage data during a charge-discharge experiment process, so as to determine a relative relationship between a voltage and dV/dQ of the experimental battery.

For example, a small current of 0.04C is used to charge and discharge the experimental battery, and the electric quantity and voltage of the experimental battery during the charging and discharging process are recorded. After obtaining these data, first removing obvious erroneous data points in these data, and then subtracting voltage and electric quantity data of a previous data point from the voltage and electric quantity data corresponding to each data point, so as to obtain dV data and dQ data of the data point. By processing all the data in sequence, a series of dV data and dQ data can be obtained, and then dQ is divided by dV to obtain a capacity-voltage differential data of the experimental battery, i.e., the ratio dV/dQ of a differential voltage to a differential capacity. Then, by using dV/dQ as a vertical coordinate and using a battery voltage corresponding to dV/dQ as a horizontal coordinate, a standard relationship curve between the voltage and dV/dQ can be obtained.

S302, determining a relationship curve between a state of charge and dV/dQ of the experimental battery, based on the relative relationship between the voltage and dV/dQ of the experimental battery, and in combination with a relative relationship between the voltage and the state of charge of the experimental battery,.

Specifically, there is a corresponding relationship between the voltage and the state of charge of the experimental battery. Based on the relative relationship between the voltage and dV/dQ of the experimental battery, in combination with the relative relationship between the voltage and the state of charge of the experimental battery, the relationship curve between the state of charge and dV/dQ of the experimental battery can be determined.

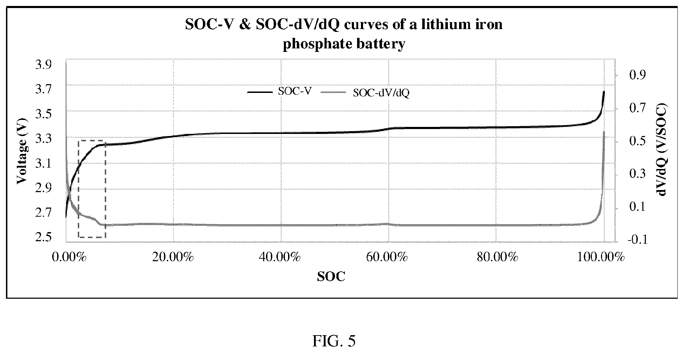

For example, FIG. 5 is a schematic diagram of an SOC-V relationship curve and an SOC-dV/dQ relationship curve of a lithium iron phosphate battery according to the embodiments of the present disclosure. Combined with FIG. 5, the capacity-voltage differential data of the lithium iron phosphate battery may be a ratio of a differential voltage to a differential electricity quantity. The curve SOC-V shows a relationship curve between the state of charge and the voltage of the lithium iron phosphate battery determined according to the small-current charge-discharge experiment. The curve SOC-dV/dQ shows a relationship curve between the state of charge and the capacity-voltage differential data of the lithium iron phosphate battery determined according to the small-current charge-discharge experiment. It can be obtained from the slopes of the curves X and Y that, when the state of charge is in a range of 4.5-98%, the differential data of the voltage and the capacity-voltage of the lithium iron phosphate battery changes slowly with charging and discharging. In contrast, when the state of charge is in a range of 0-4.5% or 98-100%, the differential data of the voltage and the capacity voltage of the lithium iron phosphate battery changes quickly with charging and discharging.

S303, determining, according to the relationship curve, a state of charge interval in which an absolute value of a curve slope is greater than a first preset value.

Specifically, according to the relationship curve between the state of charge and the capacity-voltage differential data of the experimental battery, a change in the slope of the curve may be determined. The absolute value of the slope may indicate the rate of change of the capacity-voltage differential data with respect to the state of charge. The larger the absolute value of the slope is, the faster the capacity-voltage differential data changes with respect to the state of charge. With the change of the electric quantity, the battery voltage also changes significantly, and it is more convenient to measure the voltage drop caused by self-discharge during the standing process. Therefore, by determining the preset state of charge within the state of charge interval in which the absolute value of the slope of the curve is greater than the first preset value, the system error can be reduced. For example, the first preset value may be equal to 0.05.

S304, determining a preset state of charge of the batteries to be screened by removing a low-charge interval and a high-charge interval from the state of charge interval.

Specifically, the low-charge interval refers to a state of charge interval in which the state of charge is approximately 0%. The inventors have found through research that if the battery to be screened is adjusted to the low-charge interval and then the voltage drop per unit time is measured, the self-discharge during the standing state may easily cause the battery to be screened to reach an electric quantity of 0 before the standing is completed, resulting in inaccurate measurement of voltage drop per unit time. Therefore, the state of charge in the low-charge interval is not suitable as the preset state of charge. For example, the low-charge interval may include a state of charge between 0 and 0.5%.

The high-charge interval refers to a state of charge interval in which the state of charge is approximately 100%. The inventors have found through research that if the battery to be screened is adjusted to the high-charge interval and then the voltage drop per unit time is measured, considering that the large number of a single batch of batteries to be screened, a safety risk of self-discharge during standing is high, and therefore, the state of charge in the high-charge interval is also not suitable as the preset state of charge. For example, the high-charge interval may include a state of charge of 60% to a state of charge of 100%. By removing the low-charge interval and the high-charge interval from the state of charge interval, the preset state of charge of the battery to be screened can be determined.

For example, continuing to refer to FIG. 5, according to the relationship curve between the state of charge and capacity-voltage differential data of the lithium iron phosphate battery, it may be determined that the state of charge intervals in which the absolute value of the slope of the curve is greater than 0.05 are 0%-4.5% and 98%-100%. The low-charge interval 0-0.5% and the high-charge interval 98-100% are removed from the state of charge interval, and it can be obtained that the preset state of charge of the lithium iron phosphate battery is 0.5-4.5%, which is shown in a dotted box.

S305, adjusting a plurality of batteries to be screened to the preset state of charge.

S306, measuring voltage drops per unit time of the plurality of batteries to be screened.

S307, determining voltage drop screening thresholds of a plurality of trays according to the voltage drops per unit time of the batteries to be screened in the trays.

S308, screening out unqualified batteries in the plurality of trays respectively according to a relative relationship between the voltage drop screening threshold of the tray and the voltage drops per unit time of a plurality of batteries to be screened in the tray.

Step S305 and the aforementioned step S203, step S306 and the aforementioned step S204, step S307 and the aforementioned step S205, and step S308 and the aforementioned step S203 respectively correspond to each other and have the same contents, and details are not repeated herein.

According to the self-discharge screening method for lithium-ion batteries provided by this embodiment, before measuring the voltage drops per unit time of the plurality of batteries to be screened, the relative relationship between the voltage and dV/dQ of an experimental battery is determined according to the charging/-discharging data of the experimental battery. Bases on the relative relationship between the voltage and dV/dQ of the experimental battery, combined with the relative relationship between the voltage and the state of charge of the experimental battery, the relationship curve between the state of charge and capacity-voltage differential data of the experimental battery is determined. The preset state of charge is determined according to the slope of the relationship curve, thereby realizing the determination and unification of the state of charge of the batteries to be screened. Under the preset state of charge, the voltage drops of the batteries to be screened during a self-discharge process is significant, thereby reducing the influence of system errors on the screening accuracy.

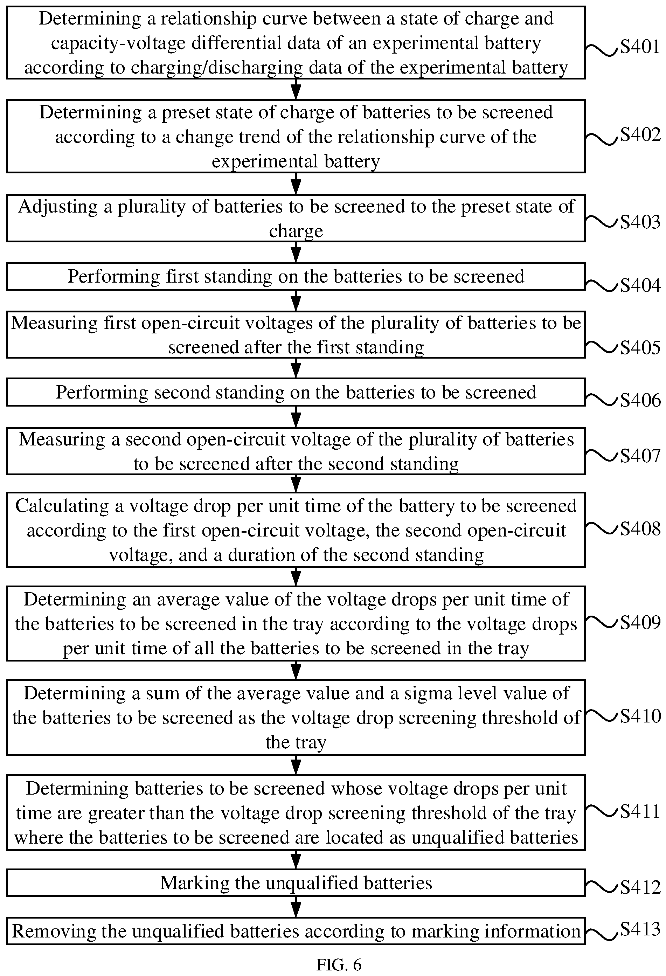

FIG. 6 is a schematic flowchart of still another self-discharge screening method for lithium-ion batteries provided by the embodiments of the present disclosure. With reference to FIG. 6, the self-discharge screening method for lithium-ion batteries includes:

S401, determining a relationship curve between a state of charge and capacity-voltage differential data of an experimental battery according to charging/-discharging data of the experimental battery.

S402, determining, according to a change trend of the relationship curve of the experimental battery, a preset state of charge of batteries to be screened.

S403, adjusting a plurality of batteries to be screened to the preset state of charge.

Step S401 and the aforementioned step S201, step S402 and the aforementioned step S202, and step S403 and the aforementioned step S203, have one-to-one correspondence and the same contents, and details are not repeated herein.

S404, performing first standing on the batteries to be screened.

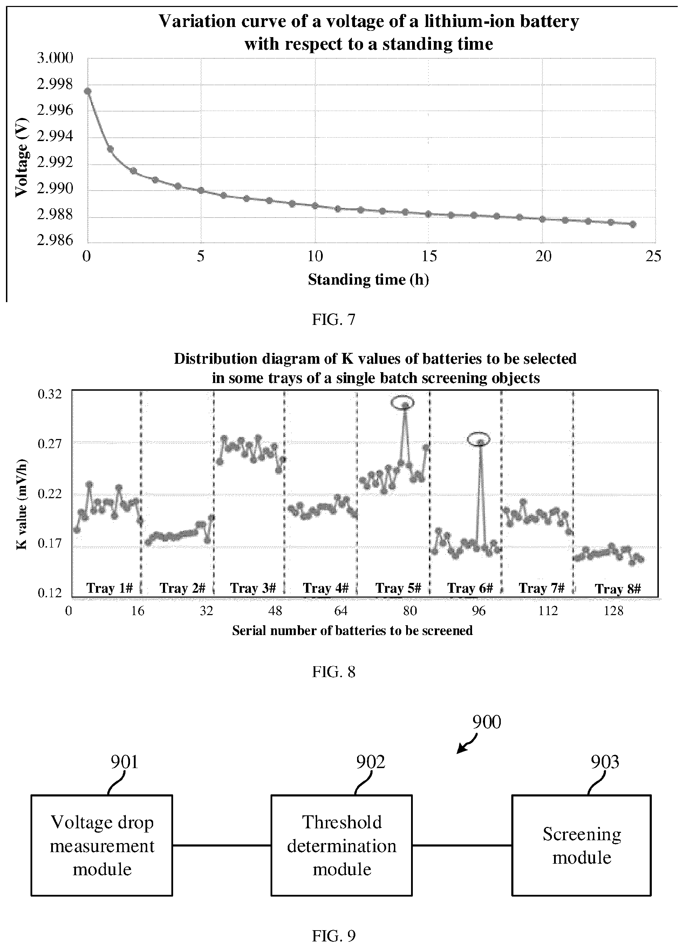

Specifically, FIG. 7 is a schematic diagram of a curve showing a voltage change of a lithium-ion battery with respect to a standing time according to the present disclosure. With reference to FIG. 7, for a battery that has just undergone charging and discharging, the voltage drops rapidly in the early stage of standing, and then the drop rate tends to stabilize. However, the time intervals of different batteries to be screened from a previous charging/discharging to the current time may be different. Therefore, if the voltage before and after standing is directly measured and the K value of the battery to be screened is calculated according to the voltage before and after standing and a standing duration, the K value obtained will have a larger error compared with an actual value. Therefore, in the embodiments of the present disclosure, the first standing is first performed on a plurality of batteries to be screened that are under a preset state of charge, so that the self-discharge speed tends to a stable value, eliminating the influence of polarization on the self-discharge speed of the batteries. Conditions of the first standing include time conditions and temperature conditions. For example, the temperature of the first standing may be equivalent to the temperature of an application condition of the batteries to be screened, the duration of the first standing can be set according to the time from the completion of charging and discharging to the time when the voltage reduction rate tends to stabilize in the experiment. The temperature of the first standing may be any value from 20°C to 30°C, and the duration of the first standing may be any value from 8 hours to 16 hours. For example, the temperature of the first standing may be 25°C and the temperature may be 10 hours.

S405, measuring first open-circuit voltages of the plurality of batteries to be screened after the first standing.

Specifically, the first standing may eliminate the influence of polarization phenomena on the battery voltage. After the first standing, the rate of decrease of the battery voltage will remain stable, and at this time, the open-circuit voltage of the battery to be screened is measured as the first open-circuit voltage.

S406, performing second standing on the batteries to be screened.

Specifically, the standing temperature of the second standing is consistent with that of the first standing. In order to make the self-discharge voltage drop in the second standing more obvious and reduce the influence of the system errors on the calculation result, the standing duration of the second standing may be longer than that of the first standing. For example, the duration of the second standing may be any value between 60 hours to 90 hours. For example, the duration of the second standing may be 70 hours, and the temperature of the second standing is the same as that of the first standing, which may be 25°C.

S407, measuring a second open-circuit voltage of the plurality of batteries to be screened after the second standing.

Specifically, during the second standing, the plurality of batteries to be screened all generate a certain voltage drop due to self-discharge. After the second standing is completed, the voltage of the batteries to be screened may be measured as the second open-circuit voltage of the batteries to be screened.

S408, calculating a voltage drop per unit time of the battery to be screened according to the first open-circuit voltage, the second open-circuit voltage, and a duration of the second standing.

Specifically, a difference between the first open-circuit voltage and the second open-circuit voltage may be regarded as the voltage drop caused by self-discharge during the second standing. In addition, by dividing the duration of the second standing by the voltage drop caused by self-discharge during the second standing, the voltage drop per unit time of the battery to be screened can be obtained. The same as a specific expression of the foregoing fixed K value screening method, a formula for calculating a voltage drop per unit time of a battery to be screened may be K value = (OCV1-OCV2)/t, in which the K value is a voltage drop per unit time of the battery to be screened, OCV1 is a first open-circuit voltage, OCV2 is a second open-circuit voltage, and t is a duration of the second standing. According to this formula, voltage drops per unit time of all the batteries to be screened in a single batch screening are calculated.

For example, FIG. 8 is a distribution diagram of K values of batteries to be screened in some trays of a single batch of objects to be screened provided in the embodiments of the present disclosure. With reference to FIG. 8, ten of thousands of batteries to be screened are included in the single batch of objects to be screened. Under this large-scale production manner, the consistency of the K values of the batteries to be screened in a single tray is better, while the consistency of the K values of the batteries to be screened in different trays is poor. The reason is that a vertical height of a standing warehouse is generally more than 10 meters, during the second standing, each of the batteries to be screened is located in a different position in the standing warehouse. The differences in the position distribution of a plurality of trays in the standing warehouse and the self-discharge heat generation of some batteries causes differences in the ambient temperature of each tray. For a plurality of batteries to be screened in the same tray, their vertical distance is 0 and the horizontal distance is small, and the difference between the K values is small, so that it is easier to determine batteries with abnormal self-discharge in a single tray according to the K values.

S409, determining an average value of the voltage drops per unit time of the batteries to be screened in the tray according to the voltage drops per unit time of all the batteries to be screened in the tray.

Specifically, according to the voltage drop per unit time of all the batteries to be screened in the tray, an average value of the voltage drops per unit time of the batteries to be screened in the tray may be determined. For example, the average value may be an arithmetic average value, which is calculated by dividing the number of the batteries to be screened in the tray by a sum of the voltage drops per unit time of all the batteries to be screened in the tray. The calculation formula is expressed as: $\overline{K} = (K_1 + K_2 + ... K_n)/n$, in which $\overline{K}$ is an average value of voltage drops per unit time of the batteries to be screened in the tray, $K_n$ is a voltage drop per unit time of the nth battery to be screened in the tray, and n is the number of batteries to be measured in the tray. The average value may also be a tail-removed average value, which may be calculated by removing the batteries to be screened having the maximum voltage drop and the minimum voltage drop per unit time in the tray, and dividing the total number of the remaining batteries to be screened by the sum of the voltage drops per unit time of the remaining batteries to be screened. In this manner, calculation of the average values corresponding to all trays in a single batch screening is completed.

S410, determining a sum of the average value and a sigma level value of the batteries to be screened as the voltage drop screening threshold of the tray.

Specifically, when determining the voltage drop screening threshold, the tray is taken as a unit, and a corresponding voltage drop screening threshold is calculated for each tray according to an average value of the voltage drops per unit time of the batteries to be screened in the tray. The voltage drop screening threshold is taken as a voltage drop judgement threshold for a plurality of batteries to be screened in a corresponding tray, and is configured to judge whether the voltage drops per unit time of the plurality of batteries to be screened are normal. The sigma level value is a product of a standard deviation and a weight constant, where the standard deviation refers to a standard deviation of the voltage drops per unit time of all the batteries to be tested in a tray where the batteries to be tested are located, and is expressed by a calculation formula:

$$\sigma = \sqrt{\sum[(K_1 - \overline{K})^2 + (K_2 - \overline{K}) + (K_2 - \overline{K})]} ,$$

in which $\sigma$ is a standard deviation. The value of the weight constant is respectively related to an initial set value and experimental data of battery disassembly, where the value of the weight constant in an initial batch screening is equal to the initial set value. For example, the initial set value is any value between 2 and 3. The experimental data of battery disassembly is experimental data obtained by disassembling the unqualified batteries in historical screenings. Before the disassembling experiment, it is necessary to store the unqualified batteries to be disassembled for a long period of time, and it is determined in the disassembling experiment whether the unqualified batteries have short circuit points, so as to record and generate the battery disassembly experiment data. For example, a long-term storage time may be greater than 30 days.

For example, the initial set value may be set to 2. If the factory needs are strict, the initial set value may be set to a smaller value. If the factory needs are loose, the initial set value may be set to a larger value. The smaller the weight constant is, the more unqualified batteriess are screened out, and the higher the effectiveness of screening is. However, some of the unqualified batteries screened out may be good products. Therefore, the value of the weight constant in the initial batch screening may be equal to the initial set value, so as to determine a first batch of unqualified batteries, and the unqualified batteries screened out can be further disassembled using a battery disassembly experiment, so as to confirm whether the unqualified batteries screened out for the first time have short-circuit points. The effectiveness of the previous screening is determined according to the experimental data of the disassembly experiments, thereby further correcting the weight constant. In subsequent screening, a corrected weight constant may be used for screening. If the weight constant needs to be further corrected, a disassembly experiment may be performed again on the unqualified batteries screened out last time. The voltage drop screening thresholds of all the trays are determined respectively using the above manner.

S411, determining batteries to be screened whose voltage drops per unit time are greater than the voltage drop screening threshold of the tray where the batteries to be screened are located as unqualified batteries.

Specifically, it is determined, according to whether the voltage drops per unit time of the plurality of batteries to be screened are greater than the voltage drop screening threshold corresponding to the tray where the batteries to be screened are located, whether the batteries to be screened are unqualified batteries. The batteries to be screened whose voltage drops per unit time are greater than the voltage drop screening threshold of the tray where the batteries to be screened are located are determined as unqualified batteries. Referring to FIG. 8, the batteries enclosed in tray 5 and tray 6 are unqualified batteries.

S412, marking the unqualified batteries.

Specifically, the unqualified batteries are marked according to the determination result of step S411. The marking manner may be setting marking information on the surface of the unqualified batteries, or adding marking information before or after archived serial numbers of the unqualified batteries.

S413, removing the unqualified batteries according to marking information.

Specifically, the unqualified batteries with marking information are removed from the batteries to be screened. For example, a surface image of the battery to be screened can be identified by using an image recognition technology, so as to determine an unqualified battery with marking information on its surface, and a mechanical arm is used to pick up the unqualified battery from the batteries to be screened. It is also possible to query the target placement location corresponding to the unqualified battery with marking information in the archive number, and then use the robotic arm to pick up the unqualified battery at the target placement location According to the self-discharge screening method for lithium-ion batteries provided by this embodiment, before measuring the voltage drops per unit time of a plurality of batteries to be screened, an experimental battery with the same material system as that of a current batch screening objects is used to determine a preset state of charge. In this process, a relationship curve between a state of charge and capacity-voltage differential data of the experimental battery is determined according to charging/-discharging data of the experimental battery, and then the preset state of charge of the battery to be screened is determined according to a change trend of the relationship curve of the experimental battery. The states of charge of the plurality of batteries to be screened are adjusted to the preset state of charge, and then further screening is performed. Due to the different voltage drops caused by self-discharge of a fixed amount of electricity from the batteries to be screened under different states of charge, the uniform adjustment of the state of charge to the preset state of charge can avoid the influence of the states of charges on the K values of a plurality of batteries to be screened, and the accuracy of self discharge screening can be further improved.

The embodiments of the present disclosure further provide a self-discharge screening apparatus for lithium-ion batteries. FIG. 9 is a schematic diagram of a composition of a self-discharge screening apparatus for lithium-ion batteries provided by the embodiments of the present disclosure. With reference to FIG. 9, the self-discharge screening apparatus 900 for lithium-ion batteries includes: a voltage drop measurement module 901, a threshold determination module 902, and a screening module 903. The voltage drop measurement module 901 is configured to measure voltage drops per unit time of a plurality of batteries to be screened. The threshold determination module 902 is configured to determine voltage drop screening thresholds of a plurality of trays according to the voltage drops per unit time of the batteries to be screened in the trays. The selection module 903 is configured to screen out unqualified batteries in the plurality of trays respectively according to a relative relationship between a voltage drop screening threshold of the tray and the voltage drops per unit time of a plurality of batteries to be screened in the tray.

The embodiments of the present disclosure further provides an electronic device. The electronic device includes: at least one processor, and a memory communicatively coupled to the at least one processor. The memory stores a computer program executable by the at least one processor. The computer program is executed by the at least one processor, so that the at least one processor can execute any self-discharge screening method for lithium-ion batteries in the embodiments of the present disclosure.

The above-mentioned product can execute the method provided by any embodiment of the present disclosure, and has corresponding functional modules and beneficial effects for executing the method.

## Claims

1. A self-discharge screening method for lithium-ion batteries, wherein a single batch screening objects of the self-discharge screening method for lithium-ion batteries comprise batteries to be screened placed in a plurality of trays, wherein each tray is placed with a plurality of the batteries to be screened; the self-discharge screening method for lithium-ion batteries comprises:

measuring voltage drops per unit time of a plurality of the batteries to be screened;
determining voltage drop screening thresholds of the plurality of trays according to the voltage drops per unit time of the batteries to be screened in the tray; and
screening out unqualified batteries in the plurality of trays respectively according to a relative relationship between the voltage drop screening threshold of the tray and the voltage drops per unit time of the plurality of batteries to be screened in the tray.

2. The self-discharge screening method for lithium-ion batteries according to claim 1, wherein before measuring voltage drops per unit time of the plurality of the batteries to be screened, the method further comprises:

determining a relationship curve between a state of charge and capacity-voltage differential data of an experimental battery according to charging/discharging data of the experimental battery; wherein a material system of the experimental battery is the same as that of the batteries to be screened;
determining a preset state of charge of the batteries to be screened according to a change trend of the relationship curve of the experimental battery; and

adjusting the plurality of batteries to be screened to the preset charge state.

3. The self-discharge screening method for lithium-ion batteries according to claim 2, wherein material systems of the experimental battery and the batteries to be screened are both lithium iron phosphate; the capacity-voltage differential data comprises a ratio dV/dQ of a differential voltage to a differential capacity;

wherein the determining a relationship curve between a state of charge and capacity-voltage differential data of an experimental battery according to charging/discharging data of the experimental battery comprises:

determining a relative relationship between a voltage and dV/dQ of the experimental battery according to the charging/discharging data of the experimental battery; and

determining a relationship curve between the state of charge and dV/dQ of the experimental battery, based on the relative relationship between the voltage and dV/dQ of the experimental battery, and in combination with a relative relationship between the voltage and the state of charge of the experimental battery.

4. The self-discharge screening method for lithium-ion batteries according to claim 2, wherein the determining a preset state of charge of the batteries to be screened according to a change trend of the relationship curve of the experimental battery comprises:

determining a state of charge interval in which an absolute value of a curve slope of the relationship curve is greater than a first preset value; and

determining the preset state of charge of the batteries to be screened by removing a low-charge interval and a high-charge interval from the state of charge interval.

5. The self-discharge screening method for lithium-ion batteries according to claim 1, wherein the measuring voltage drops per unit time of a plurality of the batteries to be screened comprises:

performing first standing on the batteries to be screened;

measuring first open-circuit voltages of the plurality of the batteries to be screened after the first standing;

performing second standing on the batteries to be screened; wherein a standing temperature of the second standing is consistent with that of the first standing;

measuring second open-circuit voltages of the plurality of the batteries to be screened after the second standing; and

calculating a voltage drop per unit time of the battery to be screened according to the first open-circuit voltage, the second open-circuit voltage, and a duration of the second standing.

6. The self-discharge screening method for lithium-ion batteries according to any one of claims 1 to 5, wherein the determining voltage drop screening thresholds of the plurality of trays according to the voltage drops per unit time of the batteries to be screened in the tray comprises:

determining an average value of the voltage drops per unit time of the batteries to be screened in the tray according to the voltage drops per unit time of all the batteries to be screened in the tray;

determining a sum of the average value and a sigma level value of the batteries to be screened as the voltage drop screening threshold of the tray; and

repeating two steps of determining the average value of the voltage drops per unit time and determining the voltage drop screening threshold to complete determinations of the voltage drop screening thresholds for all of the trays in the single batch screening objects.

7. The self-discharge screening method for lithium-ion batteries according to claim 6, wherein the sigma level value is equal to a product of a weight constant and a standard deviation;

wherein the weight constant is respectively related to an initial set value and experimental data of battery disassembly; the standard deviation refers to a standard deviation of the voltage drops per unit time of all the batteries to be tested in a tray where the batteries to be tested are located.

8. The self-discharge screening method for lithium-ion batteries according to any one of claims 1 to 5, wherein the screening out unqualified batteries in the plurality of trays respectively according to a relative relationship between the voltage drop screening threshold of the tray and the voltage drops per unit time of the plurality of batteries to be screened in the tray comprises:

determining batteries to be screened whose voltage drops per unit time are greater than the voltage drop screening threshold of the tray where the batteries to be screened are located as the unqualified batteries;

marking the unqualified batteries; and
removing the unqualified batteries according to marking information.

9.  A self-discharge screening apparatus for lithium-ion batteries, comprising:

    a voltage drop measurement module configured to measure voltage drops per unit time of a plurality of batteries to be screened;
    a threshold value determination module configured to determine voltage drop screening thresholds of a plurality of trays according to the voltage drops per unit time of the batteries to be screened in the trays; and
    a screening module configured to screen out unqualified batteries in the plurality of trays respectively according to a relative relationship between a voltage drop screening threshold of the tray and the voltage drops per unit time of a plurality of batteries to be screened in the tray.

10.  An electronic device comprising:

    at least one processor; and
    a memory communicatively coupled to the at least one processor; wherein,
    the memory stores a computer program executable by the at least one processor, wherein the computer program, when executed by the at least one processor, cause the at least one processor to perform the self-discharge screening method for lithium-ion batteries of any one of claims 1 to 8.

**Variation curve of a voltage of a lithium-ion battery
with respect to a standing temperature**

FIG. 1

Measuring voltage drops per unit time of a plurality of batteries to be screened — S101

Determining voltage drop screening thresholds of a plurality of trays according to the voltage drops per unit time of the batteries to be screened in the trays — S102

Screening out unqualified batteries in the plurality of trays respectively according to a relative relationship between the voltage drop screening threshold of the tray and the voltage drops per unit time of a plurality of batteries to be screened in the tray — S103

FIG. 2

Determining a relationship curve between a state of charge and capacity-voltage differential data of an experimental battery according to charging/discharging data of the experimental battery — S201

Determining a preset state of charge of batteries to be screened according to a change trend of the relationship curve of the experimental battery — S202

Adjusting a plurality of batteries to be screened to the preset state of charge — S203

Measuring voltage drops per unit time of the plurality of batteries to be screened — S204

Determining voltage drop screening thresholds of a plurality of trays according to the voltage drops per unit time of the batteries to be screened in the trays — S205

Screening out unqualified batteries in the plurality of trays respectively according to a relative relationship between the voltage drop screening threshold of the tray and the voltage drops per unit time of a plurality of batteries to be screened in the tray — S206

FIG. 3

Determining a relative relationship between a voltage and dV/dQ of an experimental battery according to charging/discharging data of an experimental battery — S301

Determining a relationship curve between a state of charge and dV/dQ of the experimental battery, based on the relative relationship between the voltage and dV/dQ of the experimental battery, and in combination with a relative relationship between the voltage and the state of charge of the experimental battery — S302

Determining, according to the relationship curve, a state of charge interval in which an absolute value of a curve slope is greater than a first preset value — S303

Determining a preset state of charge of the batteries to be screened by removing a low-charge interval and a high-charge interval from the state of charge interval — S304

Adjusting a plurality of batteries to be screened to the preset state of charge — S305

Measuring voltage drops per unit time of the plurality of batteries to be screened — S306

Determining voltage drop screening thresholds of a plurality of trays according to the voltage drops per unit time of the batteries to be screened in the trays — S307

Screening out unqualified batteries in the plurality of trays respectively according to a relative relationship between the voltage drop screening threshold of the tray and the voltage drops per unit time of a plurality of batteries to be screened in the tray — S308

FIG. 4

FIG. 5

Determining a relationship curve between a state of charge and capacity-voltage differential data of an experimental battery according to charging/discharging data of the experimental battery — S401

Determining a preset state of charge of batteries to be screened according to a change trend of the relationship curve of the experimental battery — S402

Adjusting a plurality of batteries to be screened to the preset state of charge — S403

Performing first standing on the batteries to be screened — S404

Measuring first open-circuit voltages of the plurality of batteries to be screened after the first standing — S405

Performing second standing on the batteries to be screened — S406

Measuring a second open-circuit voltage of the plurality of batteries to be screened after the second standing — S407

Calculating a voltage drop per unit time of the battery to be screened according to the first open-circuit voltage, the second open-circuit voltage, and a duration of the second standing — S408

Determining an average value of the voltage drops per unit time of the batteries to be screened in the tray according to the voltage drops per unit time of all the batteries to be screened in the tray — S409

Determining a sum of the average value and a sigma level value of the batteries to be screened as the voltage drop screening threshold of the tray — S410

Determining batteries to be screened whose voltage drops per unit time are greater than the voltage drop screening threshold of the tray where the batteries to be screened are located as unqualified batteries — S411

Marking the unqualified batteries — S412

Removing the unqualified batteries according to marking information — S413

FIG. 6

**Variation curve of a voltage of a lithium-ion battery with respect to a standing time**

FIG. 7

**Distribution diagram of K values of batteries to be selected in some trays of a single batch screening objects**

FIG. 8

FIG. 9

**EP 4 603 851 A1**

<table>
<tr><td colspan="2">INTERNATIONAL SEARCH REPORT</td><td>International application No.<br>**PCT/CN2023/137271**</td></tr>
</table>

**A. CLASSIFICATION OF SUBJECT MATTER**

G01R 31/382(2019.01)i; G01R 31/385(2019.01)i

According to International Patent Classification (IPC) or to both national classification and IPC

**B. FIELDS SEARCHED**

Minimum documentation searched (classification system followed by classification symbols)

IPC:G01R31/-

Documentation searched other than minimum documentation to the extent that such documents are included in the fields searched

Electronic data base consulted during the international search (name of data base and, where practicable, search terms used)

CJFD, CNKI, CNTXT, WPABSC, DWPI, ENTXTC, ENTXT: 自放电, 电池, 电压, 压降, 时间, 阈值, 荷电状态, 曲线, 斜率, 容量, 均值, 水平值, 西格玛, 权重, 标准差, 磷酸铁锂, dV/dQ, 静置, 不合格, 剔除, self 1w discharg+, battery, voltage, drop, threshold, unit time, curve, slope, average

**C. DOCUMENTS CONSIDERED TO BE RELEVANT**

| Category* | Citation of document, with indication, where appropriate, of the relevant passages | Relevant to claim No. |
|---|---|---|
| PX | CN 116359753 A (EVE ENERGY CO., LTD.) 30 June 2023 (2023-06-30)<br>claims 1-10, and description, paragraphs 5-132, and figures 1-9 | 1-10 |
| X | CN 113484773 A (EVE ENERGY CO., LTD. et al.) 08 October 2021 (2021-10-08)<br>description, paragraphs 5-85 | 1, 5, 8-10 |
| Y | CN 113484773 A (EVE ENERGY CO., LTD. et al.) 08 October 2021 (2021-10-08)<br>description, paragraphs 5-85 | 2-4, 6-7 |
| Y | CN 108511823 A (WANXIANG 123 STOCK CO., LTD. et al.) 07 September 2018 (2018-09-07)<br>description, paragraphs 6-15 | 2-4 |
| Y | CN 112782597 A (HUIZHOU EVERPOWER TECHNOLOGY CO., LTD.) 11 May 2021 (2021-05-11)<br>description, paragraphs 66-75 | 6-7 |
| A | CN 104360284 A (SHANGHAI AEROSPACE POWER TECHNOLOGY CO., LTD.) 18 February 2015 (2015-02-18)<br>entire document | 1-10 |

☑ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **05 March 2024** | **11 March 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/137271** |

## C.    DOCUMENTS CONSIDERED TO BE RELEVANT

| Category* | Citation of document, with indication, where appropriate, of the relevant passages | Relevant to claim No. |
| --- | --- | --- |
| A | CN 111323712 A (HUIZHOU YIWEI JINENG CO., LTD.) 23 June 2020 (2020-06-23)<br>entire document | 1-10 |
| A | CN 113125977 A (HUIZHOU EVERPOWER TECHNOLOGY CO., LTD.) 16 July 2021 (2021-07-16)<br>entire document | 1-10 |
| A | CN 113884934 A (EVE ENERGY CO., LTD.) 04 January 2022 (2022-01-04) | 1-10 |
| A | CN 115087878 A (LG ENERGY SOLUTION LTD.) 20 September 2022 (2022-09-20)<br>entire document | 1-10 |
| A | US 2018143255 A1 (PACESETTER INC.) 24 May 2018 (2018-05-24)<br>entire document | 1-10 |

**INTERNATIONAL SEARCH REPORT**
Information on patent family members

International application No.

**PCT/CN2023/137271**

| Patent document cited in search report | | | Publication date (day/month/year) | Patent family member(s) | | | Publication date (day/month/year) |
|---|---|---|---|---|---|---|---|
| CN | 116359753 | A | 30 June 2023 | None | | | |
| CN | 113484773 | A | 08 October 2021 | None | | | |
| CN | 108511823 | A | 07 September 2018 | None | | | |
| CN | 112782597 | A | 11 May 2021 | None | | | |
| CN | 104360284 | A | 18 February 2015 | CN | 104360284 | B | 07 August 2018 |
| CN | 111323712 | A | 23 June 2020 | None | | | |
| CN | 113125977 | A | 16 July 2021 | None | | | |
| CN | 113884934 | A | 04 January 2022 | None | | | |
| CN | 115087878 | A | 20 September 2022 | US | 2023084079 | A1 | 16 March 2023 |
| | | | | KR | 20220039452 | A | 29 March 2022 |
| | | | | WO | 2022065636 | A1 | 31 March 2022 |
| | | | | EP | 4083644 | A1 | 02 November 2022 |
| US | 2018143255 | A1 | 24 May 2018 | US | 10641833 | B2 | 05 May 2020 |
| | | | | US | 2021278469 | A1 | 09 September 2021 |
| | | | | US | 11733311 | B2 | 22 August 2023 |
| | | | | US | 2020233035 | A1 | 23 July 2020 |
| | | | | US | 11041912 | B2 | 22 June 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310436085